# EUROPEAN PATENT SPECIFICATION

(11) **EP 4 034 747 B1**
(45) Date of publication and mention of the grant of the patent: **29.07.2026**
(21) Application number: 20785849.9
(22) Date of filing: 25.09.2020
(51) Int. Cl.: E21B 41/00, E21B 43/00, B63B 35/44, G06Q 10/00

(54) **COMPUTER-IMPLEMENTED METHOD FOR PROVIDING A PERFORMANCE PARAMETER VALUE BEING INDICATIVE OF A PRODUCTION PERFORMANCE OF A FLOATING HYDROCARBON PRODUCTION PLANT**
COMPUTERIMPLEMENTIERTES VERFAHREN ZUR BEREITSTELLUNG EINES LEISTUNGSPARAMETERWERTES FÜR DIE PRODUKTIONSLEISTUNG EINER SCHWIMMENDEN KOHLENWASSERSTOFFPRODUKTIONSANLAGE
PROCÉDÉ MIS EN OEUVRE PAR ORDINATEUR POUR FOURNIR UNE VALEUR DE PARAMÈTRE DE PERFORMANCE INDIQUANT UNE PERFORMANCE DE PRODUCTION D'UNE USINE DE PRODUCTION D'HYDROCARBURES FLOTTANTE

(30) Priority: 25.09.2019 NL 2023900
(43) Date of publication of application: 03.08.2022
(73) Proprietor: Single Buoy Moorings Inc., 1723 Marly (CH)
(72) Inventor: ROLLIER, Jean-Damien, 98000 Monaco (MC)
(74) Representative: Arnold & Siedsma
(86) International application number: PCT/IB2020/058996
(87) International publication number: WO 2021/059227

(56) References cited:
- US-A1- 2011 071 963
- US-A1- 2012 191 631
- US-A1- 2015 278 407
- US-A1- 2016 116 378
- US-A1- 2016 239 743
- DAVID LOTHIAN ET AL: "Asset Integrity Services for Water Injection by means of OSIsoft Connected Services", EMEA USERS CONFERENCE 2017 LONDON #OSISOFTUC, 16 October 2017 (2017-10-16), London, pages 1 - 28, XP055703097

## Description

The present invention relates to a computer-implemented method for providing a performance parameter value being indicative of a production performance of a floating hydrocarbon production plant. The invention further relates to a method for operating a fleet performance monitoring server.

Floating hydrocarbon production plants, also known as floating production, storage and offloading facilities (FPSOs), are typically floating vessels used by the offshore oil and gas industry for the production and processing of hydrocarbons, such as oil and gas. Such vessels are specifically designed to receive hydrocarbons from a nearby plant or from a subsea template, to process the hydrocarbons on board, and to store the hydrocarbons until the hydrocarbons can be offloaded onto a tanker or transported towards an onshore facility by means of a pipeline.

An advantage of FSPOs to fixed oil platforms are e.g. that they can be developed faster than fixed platforms and thereby can provide earlier cash flows. In addition, they can be moved to other platforms and as a result, they retain value and costs can be spread over several fields due to their re-deploy ability. Moreover, FPSOs are also efficient for smaller fields in which there is a high possibility to be depleted quickly. As a result, oil and gas companies can avoid the cost of installing permanent pipelines and the decommissioning process can be made easier and less costly in comparison with the traditional oil platforms.

However, in spite of their higher cost efficiency over fixed platforms, there is still a lot to gain in terms of profitability. Oil companies could lose significant production due to unplanned downtime, causing a significant loss of profits. Due to the asset-intensive nature of the industry, any small improvement in FPSO utilization can result in a large gain in revenue and cash flow. Therefore, keeping FPSOs running as long and as optimally efficient as possible with minimum failure is of crucial importance to improving profitability and maximizing returns on projects. Being able to predict a performance parameter value being indicative of a production performance of a floating hydrocarbon production plant is then advantageous US2016239743A1 discloses an apparatus for managing failure modes for condition based maintenance in marine resource production equipment. US2015278407A1 discloses systems and apparatuses for data aggregation involving a plurality of rigs to facilitate recommendations for rig management.

An object of the present invention, next to other objects, is to provide an improved and/or more reliable method for providing a performance parameter value being indicative of a production performance of a floating hydrocarbon production plant.

To meet this object, next to other objects, a computer-implemented method for providing a performance parameter according to claim 1 is provided. Specifically, a computer-implemented method for providing a performance parameter value being indicative of a production performance of a first floating hydrocarbon production plant, wherein the first plant comprises hydrocarbon processing equipment and at least one sensor for measuring a value of a process parameter of the hydrocarbon processing equipment, wherein the method comprises the steps of:
- obtaining first plant data from the first plant, wherein the first plant data comprises data generated by the sensor;
- obtaining a trained predictive model arranged for predicting or classifying the performance parameter value; and
- providing, on the basis of the trained predictive model and the first plant data, the performance parameter value for the first plant.

Using a predictive model, a performance parameter value being indicative of a production performance of the plant can be efficiently determined. It is hereby noted that the term predictive model may comprise a predictive model such as a regression model, but may also comprise a classification model or a clustering model.

Obtaining a reliable (i.e. reliably trained) predictive model is typically challenging. The method of the current disclosure is however preferably implemented in a fleet of floating plants having a substantially similar configuration. Therefore, the method preferably comprises to train a predictive model using data originating from one plant and to use this model in another plant. Preferably, the data originating from the one plant is combined with the data from the other plant in training the predictive model. Therefore, the step of obtaining the trained predictive model preferably comprises:
- obtaining plant training data from a second floating hydrocarbon production plant, wherein the plant training data comprises data generated by a sensor for measuring a process parameter value of hydrocarbon processing equipment of the second plant;
- providing a predictive model; and
- training the predictive model using the plant training data for obtaining the trained predictive model.

In a preferred embodiment, the step of obtaining the trained predictive model comprises combining the plant training data with the first plant data to obtain a set of combined plant data, and the step of training comprises training the predictive model using the set of combined plant data for obtaining the trained predictive model. Training on the basis of more data obtains a more reliable model.

It is noted that the steps of obtaining the first plant data from the first plant and obtaining the plant training data from the second plant may preferably comprise manual and/or automatic readout of the sensors of the respective plants.

In the step of providing a predictive model, a selection is made for the type of model. The predictive model may be at least one of a neural network, a random forest, a k-nearest neighbor classifier, a logistic regression model, k-means clustering model, a support vector machine, or any other suitable machine learning model. When applicable, selecting the type of predictive model may further comprise combining the model with any suitable distance or (dis)similarity measure, such as Euclidean distance, Minkowski distance, Jaccard dissimilarity measure, dynamic time warping, etc.

It will be appreciated by a person skilled in the art of predictive modelling that selecting the type of predictive model and, if applicable, the corresponding distance or (dis)similarity measure is based on the type of data that is used with the model and the type of predictive parameter the model is intended to find. For example, when the predictive parameter is indicative for a certain type of behavior of the hydrocarbon processing equipment, a neural network or a k-nearest neighbor classifier might be selected. On the other hand, when the predictive parameter is, for example, indicative for an abnormal behavior of the hydrocarbon processing equipment, a clustering model such as k-means might be selected. When the predictive parameter is indicative for a future behavior of the hydrocarbon processing equipment or indicative for future failure of the equipment, a neural network or a logistic regression model may be selected. It is noted that the examples given above are not exhaustive and many other selections are possible.

The selection of the predictive model may further comprise selecting predetermined hyper parameters, wherein the predetermined hyper parameters comprise the parameters defining the settings of the predictive model. It will be appreciated by a person skilled in the art of predictive modelling that the hyper parameters will be dependent on the type of predictive model, the type of data, the type of the predictive parameter the model is intended to find, and other conditions. Examples of hyper parameters are a number of neighbors (k) in a k-nearest neighbor classifier, a number of layers and nodes/hidden units in a neural network (and the connection between the nodes), a number of support vectors in a support vector machine, a number of clusters in a k-means clustering model, etc. Other examples of hyper parameters are a learning rate, a training batch size, and a number of training epochs.

It is not necessary to create, i.e. provide, a predictive model from scratch. It may be possible that a trained predictive model is already available. The step of providing a predictive model then includes providing a training predictive model, wherein the step of training the model includes further training the already trained model using additional plant training data. The predictive model is thereby improved.

The step of training the predictive model preferably comprises:
- the step of setting up a training scheme in which the predictive model is trained and wherein the step of setting up the training environment may comprise one of setting a learning rate, setting a number of training epochs etc.
- the step of initializing the predictive model comprising using the predetermined hyper parameters to setup the predictive model and filling the predictive model with initial values;
- the step of providing one or more elements to the training data to the predictive model;
- the step of observing an output of the predictive model in reaction to the providing of the one or more elements of the training data to the predictive model; and,
- adjusting the predictive model in accordance to the observed output and the corresponding element of the training data,
wherein the steps of feeding an element of the training data, the step of observing an output, and the step of adjusting the predictive model are repeated until some stopping criterion is met.

It is noted that the step of observing an output of the predictive model comprises a step of observing a value or a metric indicative of a correspondence between the predictive model and the training data. For example, when the type of predictive model is trained in a supervised learning scheme, such as a neural network or a k-nearest neighbor classifier, the value or the metric indicative of the correspondence between the predictive model and the training data may be an error rate. For example, when the type of predictive model is trained in an unsupervised learning scheme, such as k-means, the value or the metric indicative of the correspondence between the predictive model and the training data may be an average distance between the training data and a set of clusters defined in the predictive model.

Optionally, the step of training the predictive model further comprises the step of dividing the training data in a training set and a test set, wherein the training data set is used to train the predictive model and the test data set is used to evaluate a performance of the trained predictive model. Preferably, the step of dividing the training data comprises dividing the training data in a plurality of sets, wherein the plurality of sets is used in a cross-validation training setup. By dividing the training data in a training set and a test set, the generalization of the model can be evaluated.

A more accurate predictive model is obtained when the model is trained using production performance data. Therefore, the step of obtaining plant training data from the second plant further comprises obtaining production performance data, wherein the production performance data contains data representing a value of at least one operating parameter which is indicative of a production status of the second plant, wherein the step of training comprises training the predictive model on the basis of the production performance data. Based on the production performance data, the predictive model can be trained efficiently. Preferably, the production performance data is related to the performance parameter value to be determined. More preferably, the product performance data and the performance parameter value are related to the same production performance parameter.

It is also possible that an operator on the plant identifies an event, for instance during an inspection of the equipment or by inspecting the plant data. This may even be done remotely. An event may for instance include a malfunction or otherwise suboptimal working of equipment. Such an event may also be detected using an algorithm on the basis of plant data, for instance when a certain value reaches a predetermined threshold. An event indicator being indicative of such an event is then generated. This event indicator is preferably included as production performance data and as such included in the plant data, to be used as training data. Preferably, as with all data, the event indicator has an associated time stamp, allowing the event indicator to be correlated in time with other data for training purposes.

The occurrence or identification of an event is valuable information for training purposes of the predictive model. It is thus preferred when the predictive model is retrained based on the additionally available plant training data, including the event indicator. The method thus further comprises the steps of:
- receiving an event indicator associated with the second plant;
- in reaction to the received event indicator, obtaining the plant training data from the second plant including the received event indicator as production performance data;
- repeating the step of training the predictive model using the plant training data including the received event indicator; and
- providing the trained predictive model to the first plant.

In a preferred embodiment, the method further comprises combining the plant training data with the first plant data to obtain a set of combined plant data including the received event indicator, and the step of repeating comprises repeating the step of training the predictive model using the set of combined plant data including the received event indicator.

The occurrence or identification of an event in one plant may then be used to improve the model to be used in the first plant. As the improved predictive model is also useful in the plant associated with the event, the method further preferably comprises the step of providing the trained predictive model to the second plant. It is also possible that the trained predictive model is only provided to the second plant. The occurrence of an event in one plant can then be used to predict the same event in said plant. Retraining the model after occurrence of such an event then improves the predicting capability.

According to a preferred embodiment, the second plant comprises a plurality of plants. Accordingly, the step of obtaining plant training data comprises obtaining plant data from a plurality of plants, wherein the step of training comprises training the predictive model on the basis of the plant training data obtained from the plurality of plants. Increasing the amount of relevant data available for training improves the quality of the predictive model.

Preferably, upon receipt of an event indicator from at least one of the plurality of plants, plant training data is provided on the basis of data from the at least one plant and the model is trained on the basis of the plant training data, wherein the trained model is provided to at least another one of the plurality of plants. An event occurring in the one plant is then used to improve the predictive model to be used in the other plant, wherein the data containing the event indicator is preferably taken into account in training the predictive model.

The step of obtaining plant training data preferably comprises adding data from at least one of the plurality of plants to historical plant training data.

The method preferably further comprises one or more pre-processing steps, wherein a pre-processing step may comprise any of noise-reduction, missing value removal, missing value imputation, normalization, scaling, dimensionality reduction (such as PCA or ICA), data transform functions (such as Fourier Transform or Wavelet Transform), and other pre-processing steps.

The one or more pre-processing steps preferably further comprises a step of normalizing the plant training data of the plurality of plants, wherein the step of normalizing comprises at least obtaining normalized plant data by normalizing or scaling the plant data. In this way, factors which are specific and unique for each of the individual plants (or its equipment pieces, processing structures or sub-components) are normalized or, in other words, factored out so that these normalized data can be safely combined with (normalized) data from other plants in order to train the predictive model.

Preferably, the step of providing, on the basis of the trained predictive model and the first plant data, the performance parameter value for the first plant is performed on a first server and the step of training the predictive model is performed on a second server different from the first server, wherein the step of obtaining a trained predictive model comprises transferring the trained model from the second server to the first server. Preferably, each of the plurality of plants comprises a server for providing the performance parameter value. Preferably, the second server is located onshore.

In the above description, a performance parameter value being indicative for the production performance of plant is defined. It is advantageous to provide performance information on a lower, more detailed level of the plant. Typically, a plant comprises a plurality of hydrocarbon processing equipment subsystems, each of which is provided with at least one sensor for measuring a value of a process parameter of said each subsystem. To efficiently define a performance parameter value being indicative for the production performance of a subsystem, the method comprises the steps of:
- obtaining subsystem data from at least one of the plurality of subsystems of the first plant, wherein the subsystem data comprises data generated by the sensor of the at least one subsystem;
- obtaining a trained predictive subsystem model arranged for predicting or classifying the performance parameter value; and
- providing, on the basis of the trained predictive subsystem model and the subsystem data, the performance parameter value for the at least one subsystem,

Preferably, the step of obtaining the trained predictive subsystem model comprises:
- obtaining subsystem training data from a subsystem of the second plant, wherein the subsystem training data comprises data generated by a sensor for measuring a value of a process parameter of a subsystem of the second plant;
- providing a predictive model; and
- training the predictive model using the subsystem training data for obtaining the trained predictive subsystem model.

In a preferred embodiment, the step of obtaining the trained predictive subsystem model further comprises combining the subsystem training data with the subsystem data to obtain a set of combined subsystem data, and the step of training comprises training the predictive model using the set of combined subsystem data for obtaining the trained predictive subsystem model.

The method preferably further comprises the steps of providing a plurality of trained subsystem models and providing, on the basis of the trained predictive subsystem models and the first plant data, the performance parameter values for the subsystems.

The step of obtaining subsystem training data preferably further comprises obtaining production performance data for the subsystem of the second plant, wherein the production performance data contains data representing a value of at least one operating parameter which is indicative of a production status of the subsystem, wherein the operating parameter comprises an event indicator being indicative of an event in a subsystem of the second plant.

As described above, event data is valuable information for training purposes. Event data on the level of subsystem level may thus be used to improve the models. The method thus preferably further comprises the steps of:
- receiving the event indicator associated with the subsystem of the second plant;
- in reaction to the received event indicator, obtaining the subsystem training data including the received event indicator as production performance data;
- repeating the step of training the predictive subsystem model using the subsystem training data including the received event indicator; and
- providing the trained predictive subsystem model to the first plant.

In a preferred embodiment, the method further comprises combining the subsystem training data with the subsystem data to obtain a set of combined subsystem data including the received event indicator; and the step of repeating comprises repeating the step of training the predictive subsystem model using the set of combined subsystem data including the received event indicator.

It may be possible that an event is registered for a subsystem for which no predictive model is yet available. Preferably, each subsystem has an associated predictive model. When this is not the case, i.e. when one subsystem has not yet an associated predictive model, and an event is registered for this subsystem, a new predictive model can be created. If a predictive model is already available and a new event is registered, the existing model can be taken as a basis for the subsequent training for improvement of this predictive model. Thus, preferably, the method further comprises the steps of checking the availability of a predictive subsystem model following an event indicator associated with the subsystem of the second plant and:
- when a predictive subsystem model is already available, retraining the predictive subsystem model using the subsystem training data including the event indicator associated with subsystem of the second plant, and sending retrained predictive subsystem to the first plant for replacement;
- when a predictive subsystem model is not available, providing a predictive subsystem model and subsequently training the model using the subsystem training data including the event indicator associated with the subsystem of the second plant, and sending the trained predictive subsystem to the first plant.

In the above description, the subsystems of the first and second plants are preferably substantially the same, at least to such an extent that the respective data obtained from said subsystems are comparable for analysis. It is also possible that data from a different subsystem of the first plant is used as a basis for providing the predictive model. A plant may contain several substantially the same subsystems. Again, the data of more than one subsystem may be combined to improve the training.

According to a further aspect, a method for operating a fleet performance monitoring server is provided, wherein the fleet comprises a plurality of floating hydrocarbon production plants as described above, preferably including the plurality hydrocarbon processing equipment subsystems and associated subsystem data and models, wherein each of the plurality of plants comprises hydrocarbon processing equipment and at least one sensor for measuring a value of a process parameter of the hydrocarbon processing equipment and wherein each of the plurality of floating hydrocarbon production plants is arranged to provide a performance parameter value being indicative of its production performance.

The method comprising the steps of:
- providing a database comprising a plurality of predictive subsystem models;
- receiving plant data from each of the plurality of plants;
- receiving an event indicator from at least one of the plurality of plants being indicative of an event in a subsystem of the at least one plant;
- checking in the database the availability of a predictive subsystem model for the subsystem and:
   i. when a predictive subsystem model is already available for the subsystem, retraining the predictive subsystem model using the plant data including the event indicator from the at least one plant,
   ii. when a predictive subsystem model is not available for the subsystem, providing a predictive subsystem model and subsequently training the model using the plant data including the event indicator from the at least one plant,
- sending the predictive subsystem model to the each of the plurality of plants.

According to a further aspect, a system comprising a plurality of plants as described above is provided.

Further advantages, features and details of the floating hydrocarbon production plant and monitoring method are elucidated on the basis of the following description of preferred embodiments thereof with reference to the accompanying drawings, in which:
- figure 1 shows a top view of a preferred embodiment of the floating hydrocarbon production plant;
- figure 2 shows a close-up view of a preferred embodiment of the plant server system of the plant of figure 1;
- figure 3 shows a schematic view of a preferred embodiment of the system;
- figure 4 shows a schematic view of a processing structure.
- figure 5 schematically shows the process of providing a performance parameter value;
- figure 6 schematically shows providing the parameter on the basis of multiple plants; and
- figure 7 schematically shows a method for operating the onshore facility, in particular a server thereof.

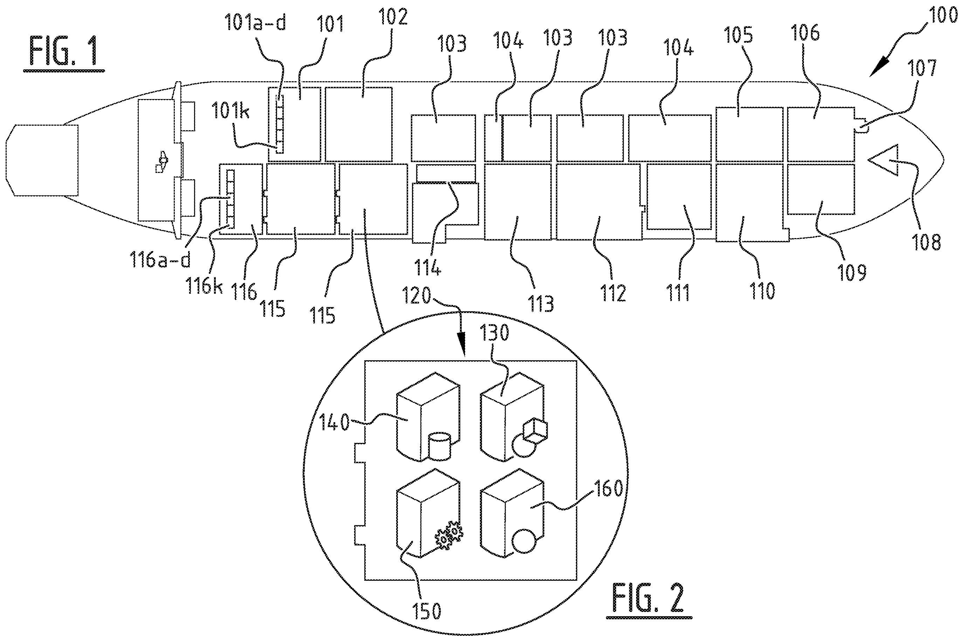

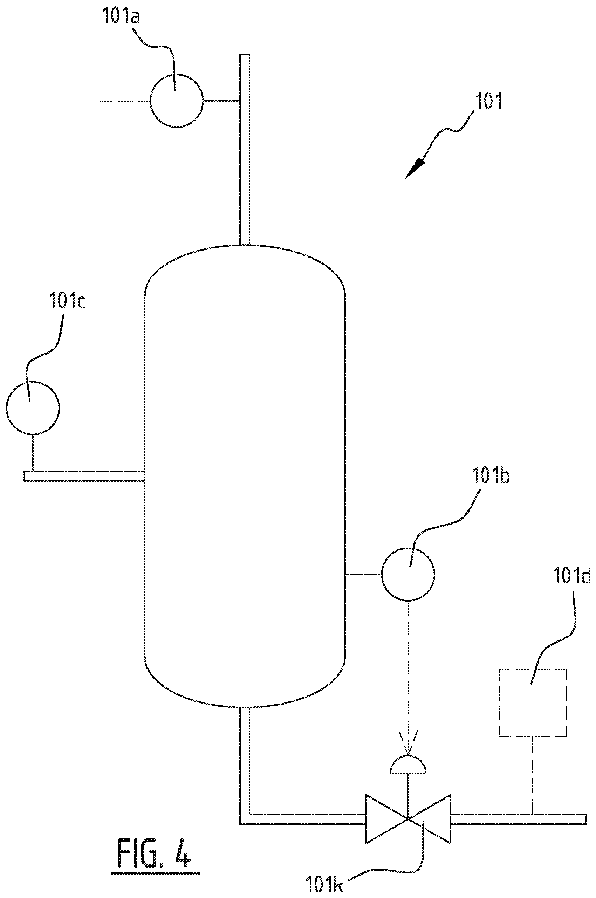

Figure 1 shows a schematic top view of a floating hydrocarbon production plant or FPSO 100, comprising several processing structures 101 to 116 which consist of several sub-components, also referred to as processing components, which are pieces of hydrocarbon processing equipment. A plurality of sensors 101a-d and possibly at least one actuator 101k (see also figure 4) is provided in association with the processing structure 101 or sub-components, i.e. hydrocarbon processing equipment. Similarly, sensors 101a-d to 116a-d are arranged to measure parameters relating to the performance of the sensor's respective structure/sub-components/equipment piece 101 to 116.

As examples of processing structures, the floating hydrocarbon production plant comprises a filter structure 101 (see also figure 4), a sea water treatment structure 102, multiple oil processing structures 103, multiple gas treatment structures 104, an injection gas compression structure 105, a flare knockout drum structure 106, a vent stack structure 107, flare stack structure 108, a main gas compression structure 109, a H₂S removal structure 110, a CO₂ membrane structure 111, a CO₂ gas compression structure 112, a main gas compression structure 113, a laydown area/chemical injection structure 114, multiple power generation structures 115, and an oil metering offloading skid structure 116. Each of these structures 101 to 116 are associated with sensors 101a-d to 116a-d which measure parameters relating to the performance of these structures and/or the performance of their sub-components, which may be pieces of hydrocarbon processing equipment.

For instance, a sensor 101a associated with a filter structure 101 measures a pressure and temperature of the inflow, while a sensor 101d may measure the outflow. Additionally, a sensor associated with an H₂S scavenger vessel of the H₂S removal structure 110 measures an H₂S scavenger vessel's performance parameter, such as an H₂S concentration after H₂S treatment by the scavenger.

The measurements of these sensors result in data which can be analyzed in order to assess the production performance of the plant 100, processing structure 101 to 116 or sub-component. Thereto, as shown in Figure 2, the floating hydrocarbon production plant 100 comprises a plant server system 120, substantially comprising four servers, viz. a data interface server 130, a data historian server 140, an analytics server 150 and a web server 160. Specifically, the data is collected by the data interface server 130 which is configured to collect the data and stream the data to the data historian server 140. Although not shown in the figures, the server system 120 ideally comprises a second data interface server which is used as a failover when the other data interface server 130 is not available due to for instance malfunction or breakdown.

The data historian server 140 allows recording and retrieving production and process data by time. It stores the information in a time-series database that can efficiently store data with minimal disk space and fast retrieval. Such time-series information is displayed in a trend or as tabular data over a time range, for example over the last day, the last week or the last year. It records data over time from one or more locations for an operator 170 to analyze. Analog readings such as temperature, pressure, flow rate or rotational speed as well as digital readings, such as discrete positions of valves and limit switches and outputs of discrete level sensors, can be recorded in the data historian server 140. Moreover, non-time-series information can be integrated in the data historian server 140 to provide greater context, e.g. processing equipment info, such as equipment IDs and material IDs, quality info, such as process and equipment limits, and aggregate data such as average, standard deviation and moving average. Other data related to the production performance of the plant 100 can be extracted from other integrated database sources and integrated/stored into the date historian server 140.

One of the important advantages of the data historian server 140 is its ability to correlate data over time, which can include for instance day shifts versus night shifts, one operator group versus another, one continuous production run versus another and/or one season versus another. The data historian server 140 can be applied independently on one or more FPSOs 100. Importantly, the data historian server 140 is especially valuable when applied across multiple FPSOs 100 within a fleet 10 of FPSOs and/or one or more FPSOs within the fleet 10 and an onshore facility 500. Using the data historian server 140 allows for instance to discover a production problem's root cause and/or to discover that two similar pieces of equipment or two similar floating hydrocarbon production plants 100, processing structures 101 to 116 or sub-components thereof produce significantly different results over time. Such information can be used for instance to detect a problem with the pieces of equipment, floating plants, processing structures or sub-components thereof as well as to factor out or normalize factors which are specific and unique for each of the individual equipment pieces, plants, processing structures or sub-components thereof, such that normalized data or calibrated data can be compared one to one and a in order to detect anomalies in the data trends.

Additionally, the data historian server 140 allows for visualization of the data, such that an operator 170 can assess the performance of equipment or the plant 100 as a whole as well as processing structures 101 to 116 or sub-components thereof and to take action if needed, for instance when the operator 170 recognizes the need for calibration, repair or replacement of for instance the equipment or a sub-component of the processing structure 101 to 116 of the plant 100. Specifically, the data historian server 140 allows to monitor and instruments to keep it operational and, as discussed, to recognize the need for calibration repair, replacement. Moreover, it enables to monitor process, a set of sub-components of a process and structure or a set of pieces of equipment in a processing structure/unit 101 to 116, to get it to operate within a set of process specifications. Moreover, the data historian server 140 allows to monitor production within a processing unit to maintain product quality within the process capability, to monitor the entire production sequence for maximum operational efficiency and flow, to monitor aspects of an FPSO 100 to optimize resource demand and consumption, to monitor multiple FPSOs 100 to strive for consistency and continuous improvement, to allow operational real-time data to integrate with business and financial systems, and/or to provide input for design experiments, prototype production systems, and continuous improvement projects.

In short, the data historian server 140 of the plant server system of the floating hydrocarbon production plant 100 provides operational data that is well organized and easily accessible, which enables an operator 170 to make informed and fast decisions to improve productivity, quality and efficiency of the FPSO 100 or fleet 10 of FPSOs 100, in particular to maximize production uptime, to optimize production efficiency, i.e. to optimize production performance of the FPSO or FPSOs 100, to maximize the FPSO's or FPSOs' operational lifetime, while at the same time preventing the stringent operational safety requirements from being compromised. Thus, the data historian server 140 allows to convert the data generated by each of the plurality of sensors 101a-d to 116a-d into actionable information upon which an operator 170 of the plant 100 can make decisions in order to optimize production in terms of uptime maximization, operational efficiency optimization, while extending or maintaining processing equipment lifetime and not compromising the safety conditions on the plant 100.

Specifically, an analytics server 150 is provided to carry out's descriptive analytics, i.e. describing the data in a way that it provides actionable information to the operator 170 of the plant 100. Moreover, the analytics server 150 enables to perform diagnostic analytics, i.e. to carry out analysis on the data, to find a trend in the data over time or to detect anomalies in the data, so that the operator 170 is assisted or instructed in its decision-making process as to operating the processing equipment, which may include adjusting equipment settings, scheduling maintenance of equipment, or shutting down equipment. Moreover, the analytics server 150 enables to create and run models on the basis of which the analysis of the data is performed, wherein results of the model-based analysis are used for assisting the operator 170 in its decision-making process. Such models may be either formula-based or data-driven, or may be a combination of both. Moreover, the analytics server 150 enables to perform predictive analytics, i.e. to run, create and/or train a predictive model which allows to carry out a predictive analysis on the data, i.e. to analyze current and historical data and/or facts on the basis of which a prediction as regards to future processing performance behavior of the processing equipment can be made which can be used to avoid any unplanned incidents which would cause unscheduled downtime.

Predictive analytics thus utilizes techniques such as machine learning and data mining to predict how the processing equipment's performance might behave in the future. Importantly the analytics server 150 is configured to carry out prescriptive analytics, i.e. to offer a recommendation to the operator 170 of the floating hydrocarbon production plant 100 on the basis of a predicted outcome.

It recommends the operator 170 actions based on historical data, external data sources and/or machine learning algorithms. The analytics server 150 allows optimizing process settings of each of the processing structures 101 to 116 and/or it sub-components, such as processing rates of each of the structures and/or sub-components, so that an average processing performance can be optimized over the lifetime of the FPSO 100.

Moreover, data of each of the individual sensors of equipment different individual structures 101 to 116, specifically of a complex set of structures, can be combined in order to gain a deeper insight into the processing performance of the plant 100, in particular into the influence of the processing performance of a first processing structure onto another processing structure associated with the first processing structure, so that process settings, such as processing rates of each of the processing structures, can be optimized.

The plant server system 120 consisting of the data interface server 130, the data historian server 140, and the analytics server 150 on the floating hydrocarbon production plant 100 enables the operator 170 to access data relating to the production performance of the plant 100, to monitor different processes and to analyze and predict, using predictive models, the production performance behavior of the plant 100, so that the plant 100 can be operated optimally when the plant 100 is located offshore. This allows for running and optimizing the plant's production performance even when a connection via a satellite 600 with an onshore facility 500 is off-line.

A web server 160 is provided to which users of the server system 120, e.g. operators 170 of the plant, can connect locally, e.g. through their personal computer's web browser, to connect to the server system 120. This allows operators 170 to connect to the server system 120 from anywhere in the world.

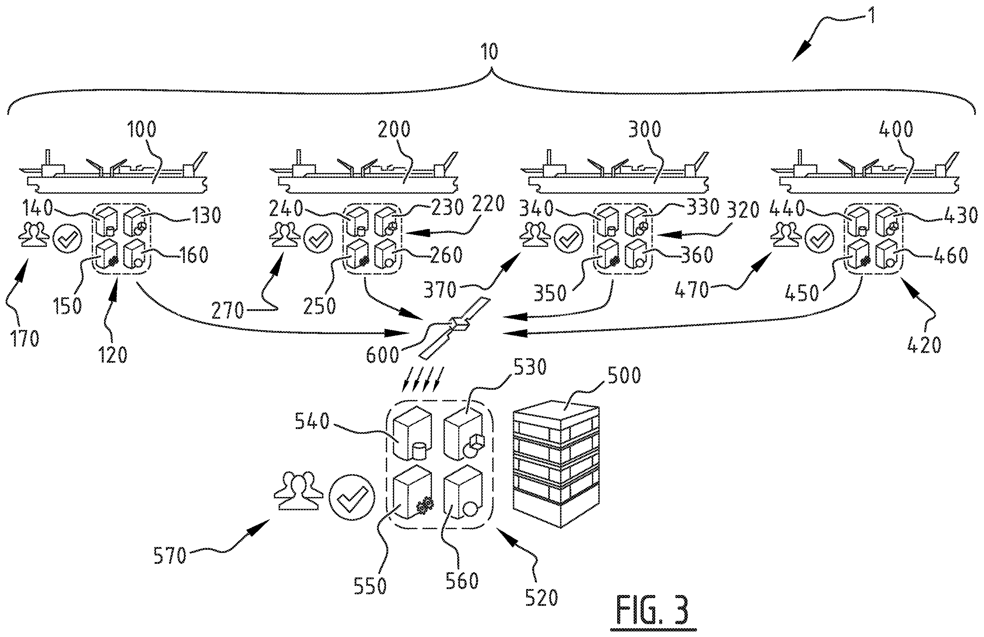

Figure 3 shows a system 1 comprising a fleet 10 of four floating hydrocarbon production plants 100; 200; 300; 400, each comprising a plant server system 120; 220; 320; 420, comprising a data interface server 130; 230; 330; 430, a data historian server 140; 240; 340; 440, an analytics server 150; 250; 350; 450 and a web server 160; 260; 360; 460, and an onshore facility 500, which comprises an onshore server system 520, comprising a data interface server 530, a data historian server 540, an analytics server 550 and a web server 560, wherein the server systems 120; 220; 320; 420 of each of the floating hydrocarbon production plants 100; 200; 300; 400 are configured to collect, store and analyze data generated by the plurality of sensors 101a-d to 416a-d of each respective one of the fleet 10 of four plants 100; 200; 300; 400, and wherein the servers of the onshore facility 500 are configured to collect, store and analyze the data generated by the plurality of sensors of all four floating hydrocarbon production plants 100; 200; 300; 400. Data communication between the onshore server system 520 and each of the plant server systems 120; 220; 320; 420 of each of the floating plants 100; 200; 300; 400 occurs through a satellite 600.

The central onshore server system 520 receives the data from the floating hydrocarbon production plants 100; 200; 300; 400 and allows performing analytics and building analytics models, which are then transferred to the floating plant, in particular the analytic servers thereof, for local use offshore. In this way, the offshore floating plants 100; 200; 300; 400 can be provided with intelligent analytics, so that each plant's data can be analysed more thoroughly offshore, so that the operator 170; 270; 370; 470 is provided with more accurate and reliable information upon which he can assess the processing equipment's processing performance and/or the production performance of the plant 100; 200; 300; 400 as a whole and take action, such as adjusting operational parameters of the processing equipment or planning maintenance, repair or replacement activities (predictive maintenance), well in advance of an otherwise unplanned event, which would cause serious downtime of the floating plant.

The onshore server system 520 of the onshore facility 500 has a data storage capacity, a data processing power and or a computing power which is larger than that of the plant server systems 120; 220; 320; 420 of each of the floating hydrocarbon production plants 100; 200; 300; 400. Specifically, due to this higher data storage capacity, the data historian server 540 of the onshore server system 520 is configured to store more data than each of the data historian servers 140; 240; 340; 440 of the plant server systems 120; 220; 320; 420 of each of the floating hydrocarbon production plants 100; 200; 300; 400. Due to its higher data processing power and computing power, the analytics server 550 of the onshore server system 520 enables processing more data and performing more complex analytics on the data than each of the analytics servers 150; 250; 350; 450 of each respective plants 100; 200; 300; 400 do.

The architecture of the onshore server system 520 of the onshore facility 500 is similar to the architecture of the plant server systems 120; 220; 320; 420. This enables to deploy the analytical results of the predictive models built using the analytics server 550 of the onshore server system 520 of the onshore facility 500 into the decision-making process on the floating hydrocarbon production plants 100; 200; 300; 400 offshore to get results, reports and outputs by automating the decisions based on the modeling. In other words, the fact that the server system architectures of the onshore server system 520 and each of plant server systems 120; 220; 320; 420 are identical allows for applying powerful analytical results of complex predictive models built in the onshore facility 500 in the analytics to be carried out by the analytics servers 150; 250; 350; 450 of each of the plant server systems 120; 220; 320; 420.

The combination of the fact that each plant server system 120; 220; 320; 420 has its own data historian server 140; 240; 340; 440 and analytics server 150; 250; 350; 450 and the fact that the higher capacity and more powerful onshore server system 520 and the plant server systems 120; 220; 320; 420 have the same architecture thus allows access the data, to analyze the data and to predict a future behavior of the production performance of each respective floating hydrocarbon production plant 100; 200; 300; 400, when each respective plant 100; 200; 300; 400 is located offshore and when a connection through the satellite 600 between the plants 100; 200; 300; 400 and the onshore facility 500 is absent.

Moreover, the fleet 10 as shown in figure 3 allows for using data of different similar floating hydrocarbon production plants 100; 200; 300; 400 in building the analytics models using the onshore server system 520. This allow for faster and more accurate model building and thus more reliable analytical results which can be incorporated into the everyday decision-making on the different production plants 100; 200; 300; 400 of the fleet 10. Specifically, external factors relating to the specific differences between the plants 100; 200; 300; 400 within the fleet 10, such as differences in the design of the processing structures 101 to 116 as well as environmental differences, such as marine and/or weather conditions, can be factored out or normalized. Such normalized data are eminently suitable for fast building of accurate and thus reliable analytics models for predicting a future behavior of the production performance of a specific plant 100; 200; 300; 400.

The present system thereby allows to improve performance by collecting and analyzing data, to reduce maintenance costs by doing maintenance only when required and identifying and solving quickly issues and downtime by monitoring the performance of the floating hydrocarbon production plant 100 locally and remotely, i.e. offshore and onshore, and by operating the plant 100 on the basis of reliable predictions using predictive modeling, thereby avoiding unplanned shutdown and trips.

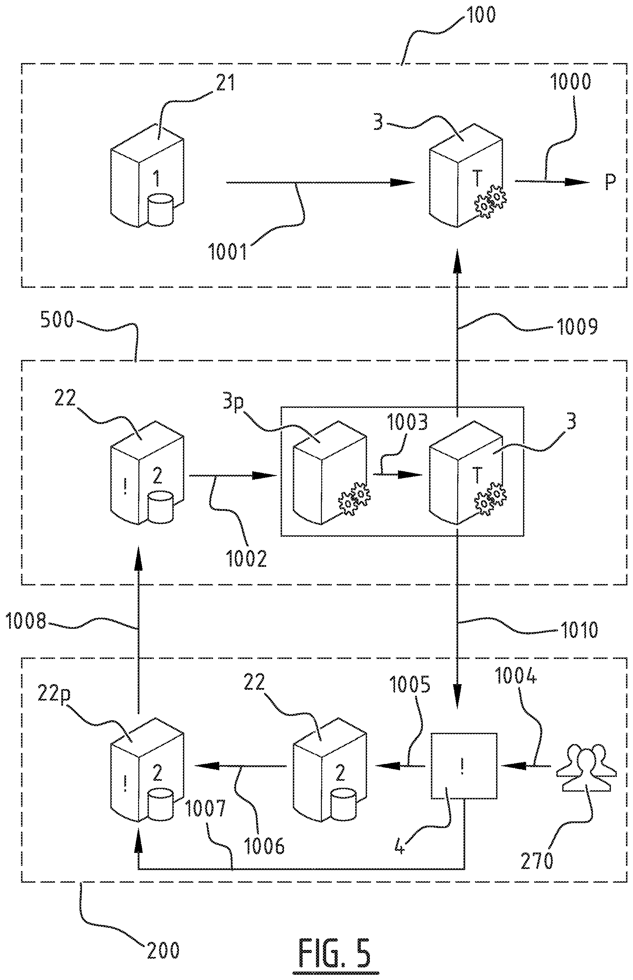

A method for providing a performance parameter value P being indicative of a production performance of a floating hydrocarbon production plant 100; 200; 300; 400 will be explained while referring to figures 5 to 7. In figure 5, a first plant 100, a second plant 200 and the onshore facility 500 are schematically shown.

The performance parameter P may be any relevant parameter indicative of the performance of the plant 100. It may for instance be indicative for the production rate or be indicative of the likelihood an event will occur in the near feature. The parameter P may for instance be indicative for the likelihood that certain equipment of subsystems will malfunction or require maintenance in the near future. The parameter P may also be a predictive value for any parameter in the production process. The parameter P may for instance be a predictive value for a certain component pressure, such that on the basis on the predictive value of the parameter P, a pressure buildup can be mitigated without any substantial pressure having built up yet. Parameter P may be used to recognize the need for calibration, repair, or replacement of any components in the plant.

In the first plant 100, plant data 21 is generated, for instance by the plurality of sensors 101a-d to 116a-d, as shown in figure 1. This plant data 21 may be stored in the data historian 140. In order to predict or to classify the performance parameter P, a trained predictive model 3 is provided. The model 3 is in this example a neural network. In a step 1001, the plant data 21 is fed to the predictive model 3 in for instance the analytics server 150 of the plant 100 and on the basis of the plant data 21 and the predictive model 3, the parameter P is defined in step 1000. The parameter P may be output using suitable output means (not shown) such as a display on a terminal on the plant 100. The parameter P may also be transmitted to the onshore facility 500 for display or processing onshore.

In this example, the predictive model 3 takes the form of an algorithm which is implemented in computer readable code which is executed by a processor, for instance of the analytics server 150 on the plant 100. The analytics server 150 thereto comprises a memory for storing the predictive model 3, preferably a plurality thereof as will be explained in more detail below. The plant data 21 may also be stored in the memory of the analytics server 150 or may be made otherwise available, for instance using a suitable data transmission between the data historian 140 and the analytics server 150.

In this example, the predictive model 3 is created and trained in the onshore facility 500, for instance in the analytic server 550 thereof. As a first step, a still untrained predictive model 3p is provided. In this step, a selection of the type of predictive model 3p is made. The type of model, for instance a neural network, a random forest, a k-nearest neighbor classifier, a logistic regression model, a principal component analysis or a support vector machine, is based on the application and/or data. The step of choosing a particular type of predictive model 3p may include receiving input from a user (for instance user 570). The user 570 may select one option from a plurality of options. The step of providing the untrained model 3p may further include the step of selecting predetermined hyper parameters which define the predictive model 3p in terms of structure in greater detail. Examples of hyper parameters of for instance a neural network are the number of layers and number of nodes (within each layer).

For training the yet untrained predictive model 3p, plant training data 22, which is available in for instance the data historian server 540 of the onshore facility 500, is fed (step 1002) to the predictive model 3p and the model is trained (step 1003). After training on the basis of the plant training data 22, the now trained predictive model 3 is capable of classifying or predicting a performance parameter value P based on plant data 21, 22. When the model 3 is trained, the predictive model 3 is transferred (step 1009) to the plant 100. This transfer 1009 may include sending the algorithm which is implemented in computer readable code from the onshore facility 500 to the plant 100, for instance to the analytic server 150 thereof.

For an optimal functioning of the predictive model 3 in the plant 100, it is preferred if the plant training data 22, on the basis of which the predictive model 3p is trained, is to a large extent similar to the plant data 21 to be processed by the model 3 for prediction and/or classification. Therefore, in this example, the plant training data 22 is obtained from a second plant 200, which is similar in configuration to the first plant 100, at least in terms of the components associated with the relevant data 21, 22. The plant training data 22 may be transferred (step1008) from a data historian server 240, via interface server 230 and satellite 600 to the onshore facility 500, i.e. the server 520 thereof. Using the data 22 from a different plant 200, improves the predictability of the parameter P in the first plant 100.

The learning process (schematically indicated by the arrow 1003) may be an unsupervised learning process. In such a process, the model 3 for instance learns to recognize, for instance by classification, unusual patterns. On the basis of any recognized unusual patterns in the plant data 21, the parameter P may be determined in step 1000.

In the example of figure 5, the learning process 1003 is a supervised learning process. Thereto, production performance data is included in the training plate data 22. In this example, the performance data contains an event indicator, generally indicated by reference numeral 4. An event may for instance be recognized (step 1004) by an operator 270 of the plant 200 or may automatically be detected from the plant data 22. The identification of a malfunctioning component, a process parameter reaching a certain threshold or even a general production parameter are examples of such an event. In a step 1007, the event indicator is included in the plant data 22, which is provided (step 1006) from for instance a plurality of onboard sensors. As said, the plant data 22 contains sensor data by time. Preferably, also the event indicator has an associated time. The plant data 22 and the event indicator are preferably stored in a time-series manner. The plant training data 22p including the event indicator 4 and the plant data 22 as such, is transferred (step 1008) and used as input for the training process 1003.

In this example, the receipt 1004 of an event indicator 4 triggers the flow of the generation of new plant training data 22p. This is indicated by the arrow 1005. As an event indicator 4 is valuable information for the training process, the receipt of such an event triggers the training process 1003. In this example, the receipt triggers the formation and transfer of the plant training data 22p. It may however also be possible that the data 22 is provided to the training facility, in this example the onshore facility 500, constantly, while the event indicator 4 is provided to the facility separately and triggers training.

The predictability of the parameter P in step 1000 is improved when the event for which the event indicator 4 is indicative is at least related to the parameter P to be determined. Preferably, the event indicator and the parameter P are related to the same process parameter. As mentioned above, the predictability is also improved when the plants 100 and 200 are to a large extent similar in construction and processing.

The process as shown in figure 5 allows making use of knowledge, i.e. the occurrence of an event in one plant 200, to be used to predict the same event in another plant 100, even when this event has not yet occurred in the other plant 100. To be able to also predict any further future events in the originating plant 200, the model 3 after training 1003 is preferably also transferred to the second plant 200, indicated with arrow 1010. The plant 200 may then predict the occurrence of such an event similar to the way this is done in plant 100.

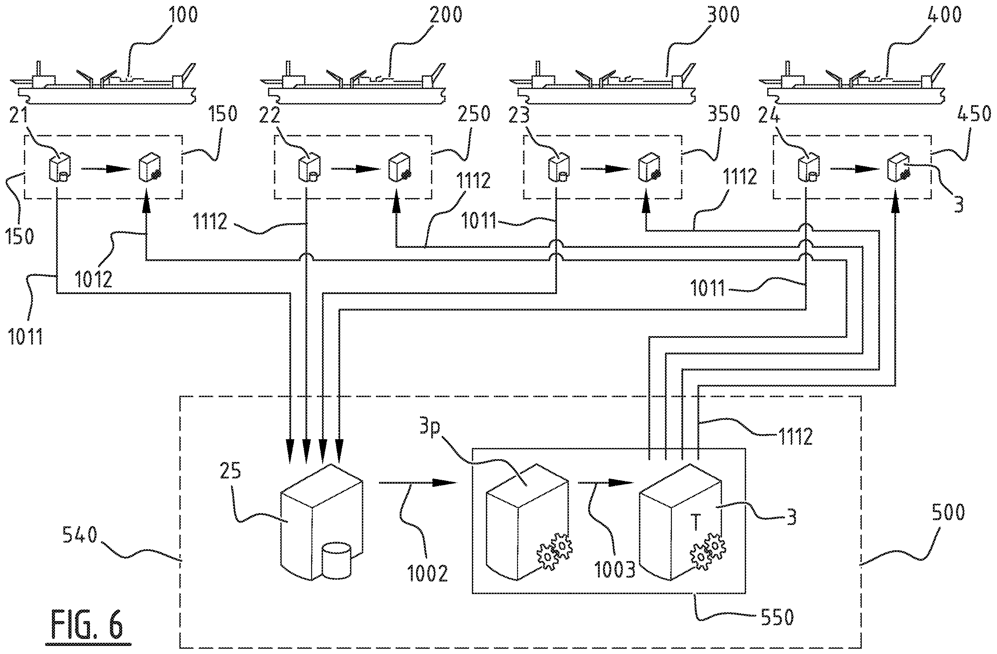

In the example of figure 5, only two plants 100, 200 were shown. It will however be appreciated that the method can be used with a plurality of plants 100 to 400, see figure 6. Each of the plants 100 to 400 is arranged to determine a performance parameter value P similar to way this is done in the ship 100 in figure 5. Each of the plants 100 to 400 comprises a server 150 to 450 provided with a predictive model 3. Plant data 21 to 24 from the respective plants 100 to 400 is provided to the predictive models 3 to determine the parameters P for each of the plants 100 to 400.

In the previous example of figure 5, plant data 22 from a single plant 200 was used as plant training data 22 for the step 1003 of training the model 3p. The step 1008 of providing the plant training data 22 from plant 200 in this example was triggered by the receipt of the event indicator 4 in this plant 200.

In the example of figure 6, plant data 21 to 24 from a plurality of plants 100 to 400 is transferred to the data historian 540, or generally the server 520, of the onshore facility 500. The step of the transfer of the data 21 to 24 is indicated with the arrows 1011. After normalization and scaling of the data, the data is collected as plant training data 25, which thus comprises the plant data 21 to 24 of a plurality of plants 100 to 400. The data 21 to 24 from each of the plants is still associated with the respective plants 100 to 400 in the data 25. This plant training data 25 is fed (step 1002) to a predictive model 3p to be trained. After training (step 1003), the predictive model 3 is distributed (step 1112) to the plurality of plants 100 to 400, or at least a part thereof. The step of training the model (step 1003) and/or distributing (step 112) may be done on regular intervals.

Similar to the process as shown in figure 5, also here the plant data 21 to 24, which is to used as plant training data 25 for training the predictive model, can comprise production performance data, for instance in the form of a event indicator as discussed above. In the case of an identified event, the process of training the model may be initiated. Also here it is advantageous that the occurrence of an event in a first plant can be used to predict this event in other plants, including the first plant.

In the above examples, only one predictive model 3 is used in the plants 100 to 400, for instance in the respective servers 120 to 420 thereof. In the example of figure 6, a plurality of predictive models 3a-c, is used for the determination of different performance parameter values. The models 3a-c may differ in type and/or configuration, i.e. in terms of hyper parameters.

In this example, the different predictive models 3a-c are used to determine different performance parameters for different hydrocarbon processing equipment subsystems 101 to 116 (see figure 1) of the respective plants 100 to 200. Data from sensors 101a-d to 116a-d from respective subsystems 101 to 116 are stored for providing subsystem data 21a-c. Subsystem data 21a for instance comprises sensor data from a first subsystem 101 of the first plant 100, while subsystem data 22b for instance comprises sensor data from subsystem 202 (not shown) of the second plant 200. The trained predictive models 3a-b which are used in the plants 100 to 200 are again provided (steps 1019 and 1040 as will be explained below) from the onshore facility 500 and function to define a subsystem performance parameter based on the subsystem data 21a, 21b, 22a, 22b. In the onshore server 520, also a plurality of predictive models 3a-b is stored in a database, generally indicated with 30.

Also here, an operator 170 of the first plant 100 may register (step 1013) an event, for instance a failure of a component in a subsystem 102. Subsystem data 21b contains sensor data from the second subsystem 102. Similar to the process as shown in the bottom of figure 5, an event indicator 4 is associated with the subsystem data 21b and this data 21b is made available (step 1014) for training. Specifically, the subsystem training data 21b is combined in the central training data 25', which also contains the subsystem data 21a-c, 22a-c of the other subsystems of the other plants 100 to 200. This dataset 25' is in a step 1016 provided as plant training data 25 for training the respective predictive model 3b associated with the subsystem data 21b associated with the registered event.

As an alternative, only the subsystem data 21b of the originating subsystem is used for training purposes. Preferably, the step of providing training data comprises at least providing subsystem data from the subsystems associated with the event from the different plants. More data is then available, which improves the training process.

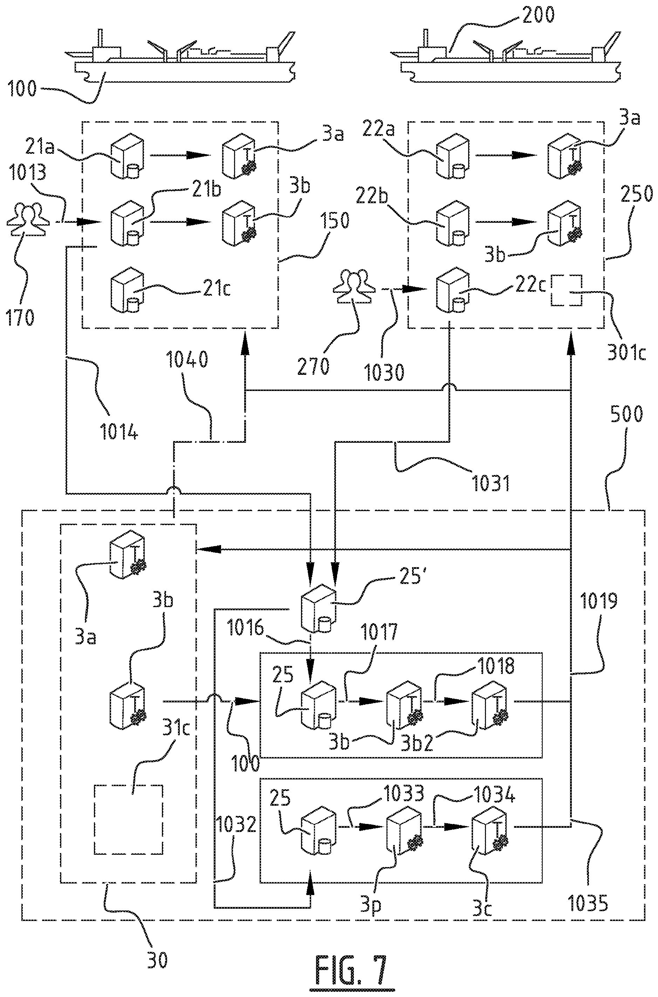

Prior to training the predictive model 3b arranged for analysis the data 21b, 22b associated with the event (step 1013), it is checked whether the database 30 already contains a predictive model 3b for the respective subsystem. In the example of figure 7, the database already contains a predictive model 3b associated with the second subsystem. In a step 1015, this already trained model 3b is used as a starting point 3b in the training process (step 1018) based on the provided (step 1017) training data 25. An improved predictive model 3b2 is thus obtained after step 1018. This predictive model 3b2 is transferred to the plants (step 1019) and replaces the already existing predictive models 3b in the respective databases of the plants 100, 200. Based on an event in a first plant 100 (step 1013) in a second subsystem 102, the respective predictive model 3b is improved and submitted to both the first plant 100 and the second 200, and any other plant.

Additionally or alternatively, the improved model 3b2 is also stored in the database 30. The existing model 3b is for instance replaced by the improved model 3b2. This is indicated with the arrow 1020. It is also possible to update the models 3a-b in the plants 100, 200 directly from the database 30, indicated with the arrow 1040.

It may also be possible that an operator 270 identifies an event (step 1030) in a third subsystem for which no predictive model (indicated with 301c) is available. Similar to the process described above, subsystem data 22c is made available (step 1031) for training purposes. Only here, as the database 30 does not yet contain a predictive model for the respective subsystem (or subsystem data 22c), instead of using the previous predictive model as a basis (step 1015 above), the step of providing a predictive model includes creating a new predictive model 3p (similar to the example in figure 5). The subsystem training data 25 is fed to the predictive model 3p and, after training (step 1034), a trained predictive model 3c is obtained. This new predictive model 3c is transferred to the respective plants 100, 200 and database 30, such that any events similar to the events registered in step 1030 can now be predicted in plants 100 and 200. Also here, it is preferred if also at least the data 21c associated with the third subsystem of the first plant 100 is made available for training.

It will be understood that although in these examples generating and training the models 3, 3a-c, 3p, takes place in the onshore facility 500, in particular a sever 520 thereof, this is not required. The steps of providing the predictive model and training the predictive model may also take place elsewhere, even in the plant 100. Instead of a physical onshore facility 500, exemplified by the building 500 in figure 3, the server 520 may be a cloud based server, or a plurality thereof. It may further be possible that instead of using plant training data 22 from another plant 200, the data 21 from the same plant 100 is used as training data for training the model 3. As said, this training may be done in the onshore facility 500, in a plant 100, 200 or the cloud.

It will further be appreciated that although some of the data are shown as separate datasets in the figures, for instance the subsystem data 21-c in a plant, this data can be stored in a single dataset with suitable attributes for distinguishing the origin of the data. The same applies to other data and model databases such as the database 30 or the provision of multiple predictive models 3a-c.

A person of skill in the art would readily recognize that steps of various above-described methods can be performed, in particular servers and server systems, can be performed by programmed computers. Herein, some embodiments are also intended to cover program storage devices, e.g., digital data storage media, which are machine or computer readable and encode machine-executable or computer-executable programs of instructions, wherein the instructions perform some or all of the steps of the above-described methods. The program storage devices may be, e.g., digital memories, magnetic storage media such as a magnetic disks and magnetic tapes, hard drives, or optically readable digital data storage media. The embodiments are also intended to cover computers programmed to perform the steps of the above-described methods.

The functions of the various elements shown in the figures, including any functional blocks labelled as "server systems", "servers", "units", "processors" or "modules", may be provided through the use of dedicated hardware as well as hardware capable of executing software such as firmware in association with appropriate software. When provided by a processor, the functions may be provided by a single dedicated processor, by a single shared processor, or by a plurality of individual processors, some of which may be shared. Moreover, explicit use of the term "server system", "server", "unit", "processor" or "controller" should not be construed to refer exclusively to hardware capable of executing software, and may implicitly include, without limitation, digital signal processor (DSP) hardware, network processor, application specific integrated circuit (ASIC), field programmable gate array (FPGA), read only memory (ROM) for storing software, random access memory (RAM), and non volatile storage. Other hardware, conventional and/or custom, may also be included. Similarly, any switches shown in the FIGS. are conceptual only. Their function may be carried out through the operation of program logic, through dedicated logic, through the interaction of program control and dedicated logic, or even manually, the particular technique being selectable by the implementer as more specifically understood from the context.

It should be appreciated by those skilled in the art that any block diagrams herein represent conceptual views of illustrative circuitry embodying the principles of the invention. Similarly, it will be appreciated that any flow charts, flow diagrams, state transition diagrams, pseudo code, and the like represent various processes which may be substantially represented in computer readable medium and so executed by a computer or processor, whether or not such computer or processor is explicitly shown.

Specifically, the terms "server system" and "server" used in the description above, may refer to a service and/or functionality, i.e. a process, rather than a physical server system or server, notwithstanding the fact that the process may be run on a dedicated server system or server which thereby provides the service and/or functionality.

The present invention is not limited to the above described preferred embodiment; the rights are defined by the claims, within the scope of which many modifications can be envisaged.

## Claims

1. Computer-implemented method for providing a performance parameter (P) value being indicative of a production performance of a first floating hydrocarbon production plant (100), wherein the first plant (100) comprises hydrocarbon processing equipment (101-116) and at least one sensor (101a-d) for measuring a value of a process parameter of the hydrocarbon processing equipment (101-116), wherein the method comprises the steps of:
- obtaining first plant data (21) from the first plant (100), wherein the first plant data (21) comprises data generated by the sensor (101a-d);
- obtaining a trained predictive model (3) arranged for predicting or classifying the performance parameter value (P); and
- providing, on the basis of the trained predictive model (3) and the first plant data (21), the performance parameter value (P) for the first plant (100),
wherein the step of obtaining the trained predictive model (3) comprises:
- obtaining plant training data (22) from a second floating hydrocarbon production plant (200), wherein the plant training data (22) comprises data generated by a sensor for measuring a process parameter value (P) of hydrocarbon processing equipment of the second plant (200), wherein the plant training data (22) comprises production performance data, wherein the production performance data contains data representing a value of at least one operating parameter which is indicative of a production status of the second plant (200), wherein the operating parameter comprises an event indicator (4) being indicative of an event in the second plant (200);
- providing a predictive model (3p); and
- training the predictive model (3p) on the basis of the production performance data using the plant training data (22) for obtaining the trained predictive model (3),
wherein the method further comprises the steps of:
- receiving the event indicator (4) associated with the second plant (200);
- in reaction to the received event indicator (4), obtaining the plant training data (22) from the second plant (200), including the received event indicator as production performance data;
- repeating the step of training the predictive model (3p) using the plant training data including the received event indicator (4); and
- providing the trained predictive model (3) to the first plant (100).

2. Method according to claim 1, wherein the step of obtaining the trained predictive model (3) further comprises combining the plant training data (22) with the first plant data (21) to obtain a set of combined plant data, and wherein the step of training comprises training the predictive model (3p) using the set of combined plant data for obtaining the trained predictive model (3).

3. Method according to claim 1 or 2, wherein the method further comprises combining the plant training data (22) with the first plant data (21) to obtain a set of combined plant data including the received event indicator (4), and wherein the step of repeating comprises repeating the step of training the predictive model (3p) using the set of combined plant data including the received event indicator (4).

4. Method according to claim 1, 2, or 3, further comprising the step of providing the trained predictive model to the second plant (200).

5. Method according to any of the claims 1 to 4, wherein the second plant (200) comprises a plurality of plants (200-400), wherein the step of obtaining plant training data (22) preferably comprises adding data from at least one of the plurality of plants (200-400) to historical training data.

6. Method according to claim 5, further comprising a step of normalizing the plant training data of the plurality of plants, wherein the step of normalizing comprises at least obtaining normalized plant data by normalizing or scaling the plant data.

7. Method according to claim 5 or 6, wherein each of the plurality of plants (200-400) comprises a server (120-420) for providing the performance parameter value (P).

8. Method according to any of the preceding claims, wherein the step of providing, on the basis of the trained predictive model (3) and the first plant data (21), the performance parameter value (P) for the first plant (100) is performed on a first server (120) and wherein the step of training the predictive model is performed on a second server (520) different from the first server (120), wherein the step of obtaining a trained predictive model (3) comprises transferring the trained model from the second server (520) to the first server (120), wherein the second server is preferably located onshore.

9. Method according to any of the preceding claims, wherein the first plant (21) comprises a plurality of hydrocarbon processing equipment subsystems (101-116), each of which is provided with at least one sensor (101a-116d) for measuring a value of a process parameter of said each subsystem (101-116), wherein the method comprises the steps of:
- obtaining subsystem data (21a-c) from at least one of the plurality of subsystems (101-116) of the first plant (100), wherein the subsystem data (21a-c) comprises data generated by the sensor of the at least one subsystem (101-116);
- obtaining a trained predictive subsystem model (3a, 3b) arranged for predicting or classifying the performance parameter value; and
- providing, on the basis of the trained predictive subsystem model (3a, 3b) and the subsystem data (21a-c), the performance parameter value for the at least one subsystem,
wherein the step of obtaining the trained predictive subsystem model comprises:
- obtaining subsystem training data (22a) from a subsystem of the second plant (200), wherein the subsystem training data (22a) comprises data generated by a sensor for measuring a value of a process parameter of a subsystem (201-206) of the second plant (200);
- providing a predictive model (3a); and
- training the predictive model using the subsystem training data for obtaining the trained predictive subsystem model wherein the step of obtaining the trained predictive subsystem model preferably further comprises combining the subsystem training data with the subsystem data to obtain a set of combined subsystem data (25'), and wherein the step of training comprises training the predictive model using the set of combined subsystem data for obtaining the trained predictive subsystem model.

10. Method according to claim 9, comprising the steps of providing a plurality of trained subsystem models (3a-c) and providing, on the basis of the trained predictive subsystem models (3a-c) and the first plant data (21a), the performance parameter values for the subsystems (101-116).

11. Method according to claim 9 or 10, wherein the step of obtaining subsystem training data further comprises obtaining production performance data for the subsystem of the second plant (200), wherein the production performance data contains data representing a value of at least one operating parameter which is indicative of a production status of the subsystem (201-216) of the second plant (200), wherein the operating parameter comprises an event indicator (4) being indicative of an event in a subsystem of the second plant (200), wherein the method further comprises the steps of:
- receiving the event indicator (4) associated with the subsystem (201-216) of the second plant (200);
- in reaction to the received event indicator, obtaining the subsystem training data including the received event indicator (4) as production performance data;
- repeating the step of training the predictive subsystem model using the subsystem training data (21a) including the received event indicator (4); and
- providing the trained predictive subsystem model to the first plant (100), wherein the method preferably further comprises combining the subsystem training data with the subsystem data to obtain a set of combined subsystem data (25') including the received event indicator (4), and wherein the step of repeating comprises repeating the step of training the predictive subsystem model using the set of combined subsystem data including the received event indicator (4).

12. Method according to claim 11, further comprising the steps of checking the availability (30/c) of a predictive subsystem model following an event indicator (4) associated with the subsystem of the second plant and:
i. when a predictive subsystem model is already available, retraining the predictive subsystem model using the subsystem training data including the event indicator associated with the subsystem of the second plant, and sending retrained predictive subsystem to the first plant for replacement;
ii. when a predictive subsystem model is not available, providing a predictive subsystem model and subsequently training the model using the subsystem training data including the event indicator associated with the subsystem of the second plant, and sending the trained predictive subsystem to the first plant.

13. Method for operating a fleet performance monitoring server (540), wherein the fleet comprises a plurality of floating hydrocarbon production plants (100-400) wherein each of the plurality of plants (100-400) comprises hydrocarbon processing equipment (101-416) and at least one sensor (101a-416d) for measuring a value of a process parameter of the hydrocarbon processing equipment, and wherein each of the plurality of floating hydrocarbon production plants (100-400) is arranged to provide a performance parameter value being indicative of its production performance, comprising the steps of:
- providing a database (25) comprising a plurality of predictive subsystem models;
- receiving plant data (21-24) from each of the plurality of plants (100-400);
- receiving an event indicator from at least one of the plurality of plants (100-400) being indicative of an event in a subsystem of the at least one plant (100-400);
- checking in the database the availability of a predictive subsystem model for the subsystem and:
i. when a predictive subsystem model is already available for the subsystem, retraining the predictive subsystem model using the plant data including the event indicator from the at least one plant,
ii. when a predictive subsystem model is not available for the subsystem, providing a predictive subsystem model and subsequently training the model using the plant data including the event indicator from the at least one plant,
- sending the predictive subsystem model to the each of the plurality of plants.

## Patentansprüche

1. Computerimplementiertes Verfahren zum Bereitstellen eines Leistungsparameterwerts (P-Wert), der eine Produktionsleistung einer ersten schwimmenden Kohlenwasserstoffproduktionsanlage (100) anzeigt, wobei die erste Anlage (100) Kohlenwasserstoffverarbeitungsausrüstung (101-116) und mindestens einen Sensor (101a-d) zum Messen eines Werts eines Prozessparameters der Kohlenwasserstoffverarbeitungsausrüstung (101-116) umfasst, wobei das Verfahren die Schritte umfasst:
- Erhalten erster Anlagendaten (21) von der ersten Anlage (100), wobei die ersten Anlagendaten (21) Daten umfassen, die von dem Sensor (101a-d) erzeugt werden;
- Erhalten eines trainierten Vorhersagemodells (3), das zum Vorhersagen oder Klassifizieren des Leistungsparameterwerts (P-Wert) ausgelegt ist; und
- Bereitstellen, auf der Grundlage des trainierten Vorhersagemodells (3) und der ersten Anlagendaten (21), des Leistungsparameterwerts (P-Wert) für die erste Anlage (100),
wobei der Schritt des Erhaltens des trainierten Vorhersagemodells (3) umfasst:
- Erhalten von Anlagentrainingsdaten (22) von einer zweiten schwimmenden Kohlenwasserstoffproduktionsanlage (200), wobei die Anlagentrainingsdaten (22) Daten umfassen, die von einem Sensor zum Messen eines Prozessparameterwerts (P-Werts) von Kohlenwasserstoffverarbeitungsausrüstung der zweiten Anlage (200) erzeugt werden, wobei die Anlagentrainingsdaten (22) Produktionsleistungsdaten umfassen, wobei die Produktionsleistungsdaten Daten enthalten, die einen Wert von mindestens einem Betriebsparameter darstellen, der einen Produktionsstatus der zweiten Anlage (200) anzeigt, wobei der Betriebsparameter einen Ereignisindikator (4) umfasst, der ein Ereignis in der zweiten Anlage (200) anzeigt;
- Bereitstellen eines Vorhersagemodells (3p); und
- Trainieren des Vorhersagemodells (3p) auf der Grundlage der Produktionsleistungsdaten unter Verwendung der Anlagentrainingsdaten (22) zum Erhalten des trainierten Vorhersagemodells (3),
wobei das Verfahren ferner die Schritte umfasst:
- Empfangen des Ereignisindikators (4), der der zweiten Anlage (200) zugeordnet ist;
- als Reaktion auf den empfangenen Ereignisindikator (4), Erhalten der Anlagentrainingsdaten (22) von der zweiten Anlage (200), einschließlich des empfangenen Ereignisindikators als Produktionsleistungsdaten;
- Wiederholen des Schritts des Trainierens des Vorhersagemodells (3p) unter Verwendung der Anlagentrainingsdaten, einschließlich des empfangenen Ereignisindikators (4); und
- Bereitstellen des trainierten Vorhersagemodells (3) für die erste Anlage (100).

2. Verfahren nach Anspruch 1, wobei der Schritt des Erhaltens des trainierten Vorhersagemodells (3) ferner ein Kombinieren der Anlagentrainingsdaten (22) mit den ersten Anlagendaten (21) umfasst, um einen Satz kombinierter Anlagendaten zu erhalten, und wobei der Schritt des Trainierens das Trainieren des Vorhersagemodells (3p) unter Verwendung des Satzes kombinierter Anlagendaten zum Erhalten des trainierten Vorhersagemodells (3) umfasst.

3. Verfahren nach Anspruch 1 oder 2, wobei das Verfahren ferner das Kombinieren der Anlagentrainingsdaten (22) mit den ersten Anlagendaten (21) umfasst, um einen Satz kombinierter Anlagendaten einschließlich des empfangenen Ereignisindikators (4) zu erhalten, und wobei der Schritt des Wiederholens das Wiederholen des Schritts des Trainierens des Vorhersagemodells (3p) unter Verwendung des Satzes kombinierter Anlagendaten einschließlich des empfangenen Ereignisindikators (4) umfasst.

4. Verfahren nach Anspruch 1, 2 oder 3, ferner umfassend den Schritt des Bereitstellens des trainierten Vorhersagemodells an die zweite Anlage (200).

5. Verfahren nach einem der Ansprüche 1 bis 4, wobei die zweite Anlage (200) eine Vielzahl von Anlagen (200-400) umfasst, wobei der Schritt des Erhaltens von Anlagentrainingsdaten (22) vorzugsweise ein Hinzufügen von Daten von mindestens einer der Vielzahl von Anlagen (200-400) zu historischen Trainingsdaten umfasst.

6. Verfahren nach Anspruch 5, ferner umfassend einen Schritt eines Normalisierens der Anlagentrainingsdaten der Vielzahl von Anlagen, wobei der Schritt des Normalisierens mindestens das Erhalten normalisierter Anlagendaten durch Normalisieren oder Skalieren der Anlagendaten umfasst.

7. Verfahren nach Anspruch 5 oder 6, wobei jede der Vielzahl von Anlagen (200-400) einen Server (120-420) zum Bereitstellen des Leistungsparameterwerts (P-Werts) umfasst.

8. Verfahren nach einem der vorstehenden Ansprüche, wobei der Schritt des Bereitstellens, auf der Grundlage des trainierten Vorhersagemodells (3) und der ersten Anlagendaten (21), des Leistungsparameterwerts (P-Werts) für die erste Anlage (100) auf einem ersten Server (120) durchgeführt wird und wobei der Schritt des Trainierens des Vorhersagemodells auf einem zweiten Server (520) durchgeführt wird, der sich von dem ersten Server (120) unterscheidet, wobei der Schritt des Erhaltens eines trainierten Vorhersagemodells (3) ein Übertragen des trainierten Modells von dem zweiten Server (520) zu dem ersten Server (120) umfasst, wobei sich der zweite Server vorzugsweise an Land befindet.

9. Verfahren nach einem der vorstehenden Ansprüche, wobei die erste Anlage (21) eine Vielzahl von Kohlenwasserstoffverarbeitungsausrüstungssubsystemen (101-116) umfasst, von denen jedes mit mindestens einem Sensor (101a-116d) zum Messen eines Werts eines Prozessparameters des jeweiligen Subsystems (101-116) bereitgestellt wird, wobei das Verfahren die Schritte umfasst:
- Erhalten von Subsystemdaten (21a-c) von mindestens einem der Vielzahl von Subsystemen (101-116) der ersten Anlage (100), wobei die Subsystemdaten (21a-c) Daten umfassen, die von dem Sensor des mindestens einen Subsystems (101-116) erzeugt werden;
- Erhalten eines trainierten Vorhersagesubsystemmodells (3a, 3b), das zum Vorhersagen oder Klassifizieren des Leistungsparameterwerts ausgelegt ist; und
- Bereitstellen, auf der Grundlage des trainierten Vorhersagesubsystemmodells (3a, 3b) und der Subsystemdaten (21a-c), des Leistungsparameterwerts für das mindestens eine Subsystem,
wobei der Schritt des Erhaltens des trainierten Vorhersagesubsystemmodells umfasst:
- Erhalten von Subsystemtrainingsdaten (22a) von einem Subsystem der zweiten Anlage (200), wobei die Subsystemtrainingsdaten (22a) Daten umfassen, die von einem Sensor zum Messen eines Werts eines Prozessparameters eines Subsystems (201-206) der zweiten Anlage (200) erzeugt werden;
- Bereitstellen eines Vorhersagemodells (3a); und
- Trainieren des Vorhersagemodells unter Verwendung der Subsystemtrainingsdaten zum Erhalten des trainierten Vorhersagesubsystemmodells, wobei der Schritt des Erhaltens des trainierten Vorhersagesubsystemmodells vorzugsweise ferner das Kombinieren der Subsystemtrainingsdaten mit den Subsystemdaten umfasst, um einen Satz kombinierter Subsystemdaten (25') zu erhalten, und wobei der Schritt des Trainierens das Trainieren des Vorhersagemodells unter Verwendung des Satzes kombinierter Subsystemdaten zum Erhalten des trainierten Vorhersagesubsystemmodells umfasst.

10. Verfahren nach Anspruch 9, umfassend die Schritte des Bereitstellens einer Vielzahl von trainierten Subsystemmodellen (3a-c) und des Bereitstellens, auf der Grundlage der trainierten Vorhersagesubsystemmodelle (3a-c) und der ersten Anlagendaten (21a), der Leistungsparameterwerte für die Subsysteme (101-116).

11. Verfahren nach Anspruch 9 oder 10, wobei der Schritt des Erhaltens von Subsystemtrainingsdaten ferner das Erhalten von Produktionsleistungsdaten für das Subsystem der zweiten Anlage (200) umfasst, wobei die Produktionsleistungsdaten Daten enthalten, die einen Wert von mindestens einem Betriebsparameter darstellen, der einen Produktionsstatus des Subsystems (201-216) der zweiten Anlage (200) anzeigt, wobei der Betriebsparameter einen Ereignisindikator (4) umfasst, der ein Ereignis in einem Subsystem der zweiten Anlage (200) anzeigt, wobei das Verfahren ferner die Schritte umfasst:
- Empfangen des Ereignisindikators (4), der dem Subsystem (201-216) der zweiten Anlage (200) zugeordnet ist;
- als Reaktion auf den empfangenen Ereignisindikator, Erhalten der Subsystemtrainingsdaten einschließlich des empfangenen Ereignisindikators (4) als Produktionsleistungsdaten;
- Wiederholen des Schritts des Trainierens des Vorhersagesubsystemmodells unter Verwendung der Subsystemtrainingsdaten (21a) einschließlich des empfangenen Ereignisindikators (4); und
- Bereitstellen des trainierten Vorhersagesubsystemmodells an die erste Anlage (100), wobei das Verfahren vorzugsweise ferner das Kombinieren der Subsystemtrainingsdaten mit den Subsystemdaten umfasst, um einen Satz kombinierter Subsystemdaten (25') einschließlich des empfangenen Ereignisindikators (4) zu erhalten, und wobei der Schritt des Wiederholens das Wiederholen des Schritts des Trainierens des Vorhersagesubsystemmodells unter Verwendung des Satzes kombinierter Subsystemdaten einschließlich des empfangenen Ereignisindikators (4) umfasst.

12. Verfahren nach Anspruch 11, ferner umfassend die Schritte eines Überprüfens der Verfügbarkeit (30/c) eines Vorhersagesubsystemmodells nach einem Ereignisindikator (4), der dem Subsystem der zweiten Anlage zugeordnet ist, und:
i. wenn ein Vorhersagesubsystemmodell bereits verfügbar ist, erneutes Trainieren des Vorhersagesubsystemmodells unter Verwendung der Subsystemtrainingsdaten einschließlich des dem Subsystem der zweiten Anlage zugeordneten Ereignisindikators und Senden des erneut trainierten Vorhersagesubsystems an die erste Anlage zum Austausch;
ii. wenn ein Vorhersagesubsystemmodell nicht verfügbar ist, Bereitstellen eines Vorhersagesubsystemmodells und anschließendes Trainieren des Modells unter Verwendung der Subsystemtrainingsdaten einschließlich des dem Subsystem der zweiten Anlage zugeordneten Ereignisindikators und Senden des trainierten Vorhersagesubsystems an die erste Anlage.

13. Verfahren zum Betreiben eines Flottenleistungsüberwachungsservers (540), wobei die Flotte eine Vielzahl von schwimmenden Kohlenwasserstoffproduktionsanlagen (100-400) umfasst, wobei jede der Vielzahl von Anlagen (100-400) Kohlenwasserstoffverarbeitungsausrüstung (101-416) und mindestens einen Sensor (101a-416d) zum Messen eines Werts eines Prozessparameters der Kohlenwasserstoffverarbeitungsausrüstung umfasst, und wobei jede der Vielzahl von schwimmenden Kohlenwasserstoffproduktionsanlagen (100-400) angeordnet ist, um einen Leistungsparameterwert bereitzustellen, der ihre Produktionsleistung anzeigt, umfassend die Schritte:
- Bereitstellen einer Datenbank (25), umfassend eine Vielzahl von Vorhersagesubsystemmodellen;
- Empfangen von Anlagendaten (21-24) von jeder der Vielzahl von Anlagen (100-400);
- Empfangen eines Ereignisindikators von mindestens einer der Vielzahl von Anlagen (100-400), der ein Ereignis in einem Subsystem der mindestens einen Anlage (100-400) anzeigt;
- Überprüfen in der Datenbank der Verfügbarkeit eines Vorhersagesubsystemmodells für das Subsystem und:
i. wenn ein Vorhersagesubsystemmodell für das Subsystem bereits verfügbar ist, erneutes Trainieren des Vorhersagesubsystemmodells unter Verwendung der Anlagendaten einschließlich des Ereignisindikators von der mindestens einen Anlage,
ii. wenn ein Vorhersagesubsystemmodell für das Subsystem nicht verfügbar ist, Bereitstellen eines Vorhersagesubsystemmodells und anschließendes Trainieren des Modells unter Verwendung der Anlagendaten einschließlich des Ereignisindikators von der mindestens einen Anlage,
- Senden des Vorhersagesubsystemmodells an jede der Vielzahl von Anlagen.

## Revendications

1. Procédé implémenté par ordinateur destiné à fournir une valeur de paramètre (P) de performance indiquant une performance de production d'une première usine (100) flottante de production d'hydrocarbures, dans lequel la première usine (100) comprend un équipement de traitement d'hydrocarbures (101 à 116) et au moins un capteur (101a à d) pour mesurer une valeur d'un paramètre de processus de l'équipement de traitement d'hydrocarbures (101 à 116), dans lequel le procédé comprend les étapes consistant à :
- obtenir des données de première usine (21) à partir de la première usine (100), dans lequel les données de première usine (21) comprennent des données générées par le capteur (101a à d) ;
- obtenir un modèle prédictif entraîné (3) agencé pour prédire ou classifier la valeur de paramètre (P) de performance ; et
- fournir, sur la base du modèle prédictif entraîné (3) et des données de première usine (21), la valeur de paramètre (P) de performance pour la première usine (100),
dans lequel l'étape consistant à obtenir le modèle prédictif entraîné (3) comprend :
- l'obtention de données d'entraînement d'usine (22) à partir d'une seconde usine (200) flottante de production d'hydrocarbures, dans lequel les données d'entraînement d'usine (22) comprennent des données générées par un capteur pour mesurer une valeur de paramètre (P) de processus d'un équipement de traitement d'hydrocarbures de la seconde usine (200), dans lequel les données d'entraînement d'usine (22) comprennent des données de performance de production, dans lequel les données de performance de production contiennent des données représentant une valeur d'au moins un paramètre de fonctionnement qui indique un statut de production de la seconde usine (200), dans lequel le paramètre de fonctionnement comprend un indicateur d'événement (4) indiquant un événement dans la seconde usine (200) ;
- la fourniture d'un modèle prédictif (3p) ; et
- l'entraînement du modèle prédictif (3p) sur la base des données de performance de production à l'aide des données d'entraînement d'usine (22) pour obtenir le modèle prédictif entraîné (3),
dans lequel le procédé comprend en outre les étapes consistant à :
- recevoir l'indicateur d'événement (4) associé à la seconde usine (200) ;
- en réaction à l'indicateur d'événement (4) reçu, obtenir les données d'entraînement d'usine (22) à partir de la seconde usine (200), comportant l'indicateur d'événement reçu en tant que données de performance de production ;
- répéter l'étape consistant à entraîner le modèle prédictif (3p) à l'aide des données d'entraînement d'usine comportant l'indicateur d'événement (4) reçu ; et
- fournir le modèle prédictif entraîné (3) à la première usine (100).

2. Procédé selon la revendication 1, dans lequel l'étape consistant à obtenir le modèle prédictif entraîné (3) comprend en outre la combinaison des données d'entraînement d'usine (22) avec les données de première usine (21) pour obtenir un ensemble de données d'usine combinées, et dans lequel l'étape consistant à entraîner comprend l'entraînement du modèle prédictif (3p) à l'aide de l'ensemble de données d'usine combinées pour obtenir le modèle prédictif entraîné (3).

3. Procédé selon la revendication 1 ou 2, dans lequel le procédé comprend en outre la combinaison des données d'entraînement d'usine (22) avec les données de première usine (21) pour obtenir un ensemble de données d'usine combinées comportant l'indicateur d'événement (4) reçu, et dans lequel l'étape consistant à répéter comprend la répétition de l'étape consistant à entraîner le modèle prédictif (3p) à l'aide de l'ensemble de données d'usine combinées comportant l'indicateur d'événement (4) reçu.

4. Procédé selon la revendication 1, 2 ou 3, comprenant en outre l'étape consistant à fournir le modèle prédictif entraîné à la seconde usine (200).

5. Procédé selon l'une quelconque des revendications 1 à 4, dans lequel la seconde usine (200) comprend une pluralité d'usines (200 à 400), dans lequel l'étape consistant à obtenir des données d'entraînement d'usine (22) comprend de préférence l'ajout de données provenant d'au moins l'une de la pluralité d'usines (200 à 400) à un historique de données d'entraînement.

6. Procédé selon la revendication 5, comprenant en outre une étape consistant à normaliser les données d'entraînement d'usine de la pluralité d'usines, dans lequel l'étape consistant à normaliser comprend au moins l'obtention de données d'usine normalisées par normalisation ou mise à l'échelle des données d'usine.

7. Procédé selon la revendication 5 ou 6, dans lequel chacune de la pluralité d'usines (200 à 400) comprend un serveur (120 à 420) destiné à fournir la valeur de paramètre (P) de performance.

8. Procédé selon l'une quelconque des revendications précédentes, dans lequel l'étape consistant à fournir, sur la base du modèle prédictif entraîné (3) et des données de première usine (21), la valeur de paramètre (P) de performance pour la première usine (100) est réalisée sur un premier serveur (120) et dans lequel l'étape consistant à entraîner le modèle prédictif est réalisée sur un second serveur (520) différent du premier serveur (120), dans lequel l'étape consistant à obtenir un modèle prédictif entraîné (3) comprend le transfert du modèle entraîné du second serveur (520) au premier serveur (120), dans lequel le second serveur est de préférence situé à terre.

9. Procédé selon l'une quelconque des revendications précédentes, dans lequel la première usine (21) comprend une pluralité de sous-systèmes (101 à 116) d'équipement de traitement d'hydrocarbures, chacun d'entre eux étant pourvu d'au moins un capteur (101a à 116d) pour mesurer une valeur d'un paramètre de processus de chaque dit sous-système (101 à 116), dans lequel le procédé comprend les étapes consistant à :
- obtenir des données de sous-système (21a à c) à partir d'au moins l'un de la pluralité de sous-systèmes (101 à 116) de la première usine (100), dans lequel les données de sous-système (21a à c) comprennent des données générées par le capteur de l'au moins un sous-système (101 à 116) ;
- obtenir un modèle de sous-système prédictif entraîné (3a, 3b) agencé pour prédire ou classifier la valeur de paramètre de performance ; et
- fournir, sur la base du modèle de sous-système prédictif entraîné (3a, 3b) et des données de sous-système (21a à c), la valeur de paramètre de performance pour l'au moins un sous-système,
dans lequel l'étape consistant à obtenir le modèle de sous-système prédictif entraîné comprend :
- l'obtention de données d'entraînement de sous-système (22a) à partir d'un sous-système de la seconde usine (200), dans lequel les données d'entraînement de sous-système (22a) comprennent des données générées par un capteur pour mesurer une valeur d'un paramètre de processus d'un sous-système (201 à 206) de la seconde usine (200) ;
- la fourniture d'un modèle prédictif (3a) ; et
- l'entraînement du modèle prédictif à l'aide des données d'entraînement de sous-système pour obtenir le modèle de sous-système prédictif entraîné dans lequel l'étape consistant à obtenir le modèle de sous-système prédictif entraîné comprend en outre de préférence la combinaison des données d'entraînement de sous-système avec les données de sous-système pour obtenir un ensemble de données de sous-système combinées (25'), et dans lequel l'étape consistant à entraîner comprend l'entraînement du modèle prédictif à l'aide de l'ensemble de données de sous-système combinées pour obtenir le modèle de sous-système prédictif entraîné.

10. Procédé selon la revendication 9, comprenant les étapes consistant à fournir une pluralité de modèles de sous-système entraînés (3a à c) et fournir, sur la base des modèles de sous-système prédictifs entraînés (3a à c) et des données de première usine (21a), les valeurs de paramètre de performance pour les sous-systèmes (101 à 116).

11. Procédé selon la revendication 9 ou 10, dans lequel l'étape consistant à obtenir des données d'entraînement de sous-système comprend en outre l'obtention de données de performance de production pour le sous-système de la seconde usine (200), dans lequel les données de performance de production contiennent des données représentant une valeur d'au moins un paramètre de fonctionnement qui indique un statut de production du sous-système (201 à 216) de la seconde usine (200), dans lequel le paramètre de fonctionnement comprend un indicateur d'événement (4) indiquant un événement dans un sous-système de la seconde usine (200), dans lequel le procédé comprend en outre les étapes consistant à :
- recevoir l'indicateur d'événement (4) associé au sous-système (201 à 216) de la seconde usine (200) ;
- en réaction à l'indicateur d'événement reçu, obtenir les données d'entraînement de sous-système comportant l'indicateur d'événement (4) reçu en tant que données de performance de production ;
- répéter l'étape consistant à entraîner le modèle de sous-système prédictif à l'aide des données d'entraînement de sous-système (21a) comportant l'indicateur d'événement (4) reçu ; et
- fournir le modèle de sous-système prédictif entraîné à la première usine (100), dans lequel le procédé comprend en outre de préférence la combinaison des données d'entraînement de sous-système avec les données de sous-système pour obtenir un ensemble de données de sous-système combinées (25') comportant l'indicateur d'événement (4) reçu, et dans lequel l'étape consistant à répéter comprend la répétition de l'étape consistant à entraîner le modèle de sous-système prédictif à l'aide de l'ensemble de données de sous-système combinées comportant l'indicateur d'événement (4) reçu.

12. Procédé selon la revendication 11, comprenant en outre les étapes consistant à vérifier la disponibilité (30/c) d'un modèle de sous-système prédictif à la suite d'un indicateur d'événement (4) associé au sous-système de la seconde usine et :
i. lorsqu'un modèle de sous-système prédictif est déjà disponible, réentraîner le modèle de sous-système prédictif à l'aide des données d'entraînement de sous-système comportant l'indicateur d'événement associé au sous-système de la seconde usine, et envoyer le sous-système prédictif réentraîné à la première usine pour remplacement ;
ii. lorsqu'un modèle de sous-système prédictif n'est pas disponible, fournir un modèle de sous-système prédictif et entraîner ensuite le modèle à l'aide des données d'entraînement de sous-système comportant l'indicateur d'événement associé au sous-système de la seconde usine, et envoyer le sous-système prédictif entraîné à la première usine.

13. Procédé de mise en fonctionnement d'un serveur de surveillance de performance de flotte (540), dans lequel la flotte comprend une pluralité d'usines (100 à 400) flottantes de production d'hydrocarbures, dans lequel chacune de la pluralité d'usines (100 à 400) comprend un équipement de traitement d'hydrocarbures (101 à 416) et au moins un capteur (101a à 416d) pour mesurer une valeur d'un paramètre de processus de l'équipement de traitement d'hydrocarbures, et dans lequel chacune de la pluralité d'usines (100 à 400) flottantes de production d'hydrocarbures est agencée pour fournir une valeur de paramètre de performance indiquant sa performance de production, comprenant les étapes consistant à :
- fournir une base de données (25) comprenant une pluralité de modèles de sous-système prédictifs ;
- recevoir des données d'usine (21 à 24) à partir de chacune de la pluralité d'usines (100 à 400) ;
- recevoir un indicateur d'événement à partir d'au moins l'une de la pluralité d'usines (100 à 400) indiquant un événement dans un sous-système de l'au moins une usine (100 à 400) ;
- vérifier dans la base de données la disponibilité d'un modèle de sous-système prédictif pour le sous-système et :
i. lorsqu'un modèle de sous-système prédictif est déjà disponible pour le sous-système, réentraîner le modèle de sous-système prédictif à l'aide des données d'usine comportant l'indicateur d'événement provenant de l'au moins une usine,
ii. lorsqu'un modèle de sous-système prédictif n'est pas disponible pour le sous-système, fournir un modèle de sous-système prédictif et ensuite entraîner le modèle à l'aide des données d'usine comportant l'indicateur d'événement provenant de l'au moins une usine,
- envoyer le modèle de sous-système prédictif à chacune de la pluralité d'usines.
